Europäisches Patentamt

(19) European Patent Office

Office européen des brevets

(11) Numéro de publication : **0 356 337 B1**

# (12) FASCICULE DE BREVET EUROPEEN

(45) Date de publication du fascicule du brevet :
09.10.91 Bulletin 91/41

(51) Int. Cl.⁵ : **H03B 9/10, H03K 3/57**

(21) Numéro de dépôt : **89402333.2**

(22) Date de dépôt : **24.08.89**

(54) **Dispositif de protection d'un modulateur à ligne à retard.**

(30) Priorité : **26.08.88 FR 8811292**

(43) Date de publication de la demande :
**28.02.90 Bulletin 90/09**

(45) Mention de la délivrance du brevet :
**09.10.91 Bulletin 91/41**

(84) Etats contractants désignés :
**CH DE GB IT LI NL SE**

(56) Documents cités :
**US-A- 3 176 158**
**US-A- 3 277 342**
**US-A- 3 881 145**
**IEEE TRANSACTIONS ON NUCLEAR
SCIENCE, vol. NS-24, no. 3, juin 1977, pages
1343-1345, New York, US; R. FAULKNERT et
al.: "The lampf line D fast deflector system"**

(73) Titulaire : **C.G.R. MeV
551, route de la Minière
F-78530 Buc (FR)**

(72) Inventeur : **Milcamps, Jacques
6, Cité d'Agry
F-92140 Clamart (FR)**
Inventeur : **Thiebaut, Jean-Pierre
42, Avenue de Villeziers
F-91400 Orsay (FR)**
Inventeur : **Pourre, Jean-Louis
31, rue de Cernay
F-91470 Les Molières (FR)**

(74) Mandataire : **Ballot, Paul Denis Jacques et al
Cabinet Ballot-Schmit 7, rue le Sueur
F-75116 Paris (FR)**

## Description

L'invention concerne les modulateurs à ligne à retard, et, plus particulièrement, un dispositif de protection de tels modulateurs.

Un modulateur à ligne à retard est destiné à fournir des impulsions à une impédance qui est constituée le plus souvent par un tube à vide, tel qu'un klystron, un magnétron, un tube à grille.

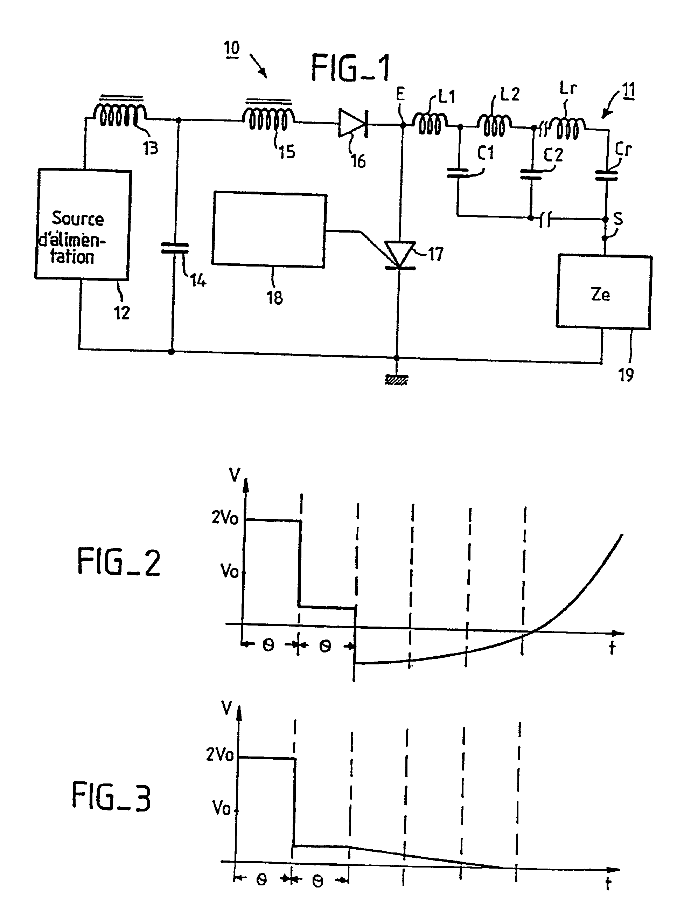

La figure 1 est un schéma électrique de principe d'un modulateur à ligne à retard 10 selon l'art antérieur. Il comprend une ligne à retard 11 dont la borne d'entrée E est connectée à un circuit de charge de la ligne à retard et à un circuit de commande de la décharge de la ligne à retard, tandis que la borne de sortie S est connectée au circuit d'utilisation 19 schématisé par une impédance Ze. La ligne à retard 11 comprend une série de cellules élémentaires constituées par un ensemble de condensateurs C1, C2....Cr et bobines L1, L2....Lr. Le circuit de charge de la ligne comprend une source d'alimentation continue 12, une bobine de filtrage 13, un condensateur de grande capacité 14, une bobine de charge 15 et une diode 16. La décharge de la ligne à retard est assurée par un thyristor 17 qui est commandé par un circuit de commande 18. Le thyristor 17 peut être remplacé par un thyratron ou, plus généralement, par un commutateur commandé.

Le fonctionnement du modulateur de la figure 1 est alors le suivant. La charge de la ligne à retard 11 est effectuée par l'intermédiaire de la diode 16 alors que le thyristor 17 n'est pas conducteur. La ligne à retard se charge et sa borne d'entrée E atteint après un certain temps un potentiel voisin de $2V_o$ si $V_o$ est la tension de la source d'alimentation 12. La durée T de cette charge est donnée par la formule :

$$T = \pi \sqrt{LC}$$

formule dans laquelle

L est la self-inductance de la bobine de charge 15 et C est la capacité équivalente des condensateurs C1, C2....Cr.

Après ce temps de charge, le thyristor 17 est rendu conducteur par un signal fourni par le circuit de commande 18, de sorte que la ligne à retard se décharge dans le circuit d'utilisation 19.

Après cette décharge, la ligne à retard peut ensuite être rechargée mais il est important que cette recharge n'ait lieu que lorsque le thyristor 17 est bloqué car s'il était conducteur, la source d'alimentation 12 serait en court-circuit.

Pour éviter un tel mauvais fonctionnement, on fait en sorte que le thyristor 17 se désamorce après la décharge de la ligne à retard. A cet effet, l'impédance équivalente Ze du circuit d'utilisation 19 est choisie plus petite que l'impédance caractéristique Zc de la ligne à retard (adaptation négative), l'impédance Zc

étant égale à $\sqrt{Le/Ce}$, formule dans laquelle :

Le est la self-inductance équivalente des bobines L1, L2....Lr, et

Ce est la capacité équivalente des condensateurs C1, C2....Cr. Par suite de ce choix des valeurs relatives de Zc et Ze, il en résulte qu'une tension négative est ramenée aux bornes du thyristor 17, après un temps θ tel que :

$$\theta = 2\sqrt{LeCe}$$

C'est cette tension négative qui désamorce le thyristor 17.

Le diagramme de la figure 2 montre l'évolution au cours du temps de la tension à la borne d'entrée E de la ligne à retard 11.

Le diagramme de la figure 3 montre l'évolution au cours du temps de la tension à la borne d'entrée de la ligne à retard lorsque Ze est choisie plus grande que Zc, ce qui correspond à une adaptation dite positive. Le thyristor 17 ne se désamorce pas et il en résulterait un court-circuit de la source d'alimentation 12 si on permettait la recharge de la ligne à retard.

Pour éviter ce mauvais fonctionnement, il a été proposé de remplacer la diode 16 par un thyristor qui serait déclenché un certain temps après l'impulsion de déclenchement du thyristor 17, mais le choix de cette durée présuppose que le courant circulant dans le circuit de décharge à cet instant est inférieur au courant de désamorçage du thyristor. Ceci n'est pas toujours le cas, notamment lorsque le circuit d'utilisation est un tube électronique dont l'impédance présentée au modulateur peut varier, par exemple en fonction de la tension appliquée, de ses conditions de fonctionnement ou lors d'un court-circuit accidentel. Le but de la présente invention est donc de réaliser un dispositif de protection d'un modulateur à la ligne à retard qui empêche la charge de la ligne à retard tant que le thyristor de commande de la décharge n'est pas désamorcé.

Dans le document IEEE transactions on Nuclear Science, Vol NS-24, n°3, juin 1977, pages 1343-1345-New-York US ; de R. FAULKNERT et al et intitulé : "the lampf line D fast deflector system", il est décrit un dispositif de charge et de décharge de ligne à retard qui a essentiellement pour but de ne décharger la ligne à retard que si la charge de cette dernière a atteint un niveau déterminé. Par ailleurs, il est prévu de limiter le courant de charge de la ligne et donc le courant dans le tube de charge pendant la durée de l'impulsion de la ligne à retard.

L'invention se rapporte donc à un dispositif de protection d'un modulateur à ligne à retard, du type comprenant un premier commutateur pour permettre la charge de la ligne à retard, et un deuxième commutateur pour permettre la décharge de la ligne à retard dans le circuit d'utilisation, caractérisé en ce qu'il comprend des premiers moyens pour fournir un signal de sortie lorsque la tension aux bornes de la ligne à retard est inférieure au seuil de conduction du deuxième commutateur et des deuxièmes moyens pour autoriser la fermeture du premier commutateur lorsque lesdits premiers moyens fournissent ledit signal de sortie. L'invention sera mieux comprise à l'aide de la description suivante d'un exemple particulier de réalisation, ladite description étant faite en relation avec les dessins joints dans lesquels :

— la figure 1 est un schéma de principe d'un modulateur à ligne à retard selon l'art antérieur,

— les figures 2 et 3 sont des diagrammes montrant les courbes de variation en fonction du temps de la tension à la borne d'entrée E de la ligne à retard, et

— la figure 4 est un schéma d'un modulateur à ligne à retard comportant un dispositif de protection selon l'invention.

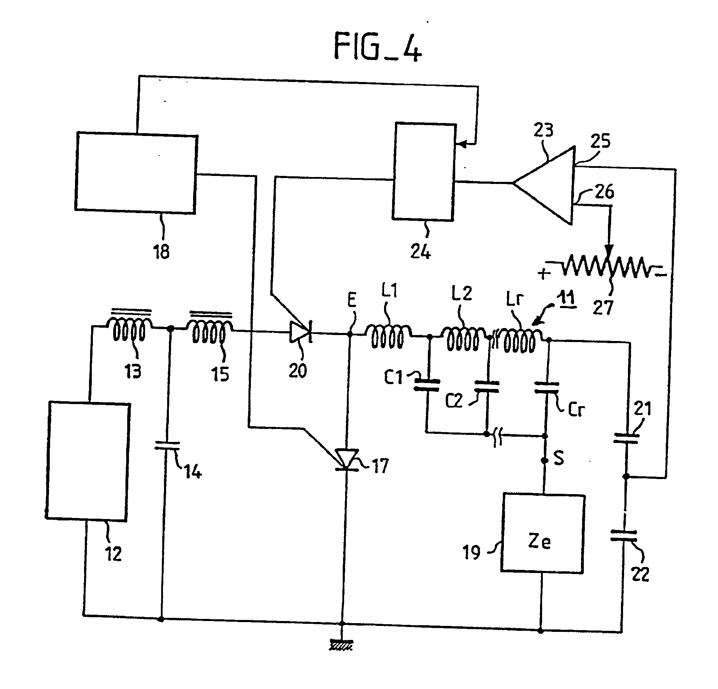

Les figures 1 à 3 ont été décrites dans le préambule pour montrer les problèmes rencontrés dans les modulateurs à ligne à retard de l'art antérieur. La figure 4 est un schéma qui comporte outre les éléments de celui de la figure 1 avec les mêmes références, un dispositif de protection selon l'invention.

L'invention consiste à interdire la recharge de la ligne à retard 11 tant que la tension aux bornes de la ligne est supérieure au seuil de désamorçage du thyristor 17. Pour contrôler la recharge de la ligne, on utilise un deuxième thyristor 20 qui remplace la diode 16 (figure 1) et qui ne peut être rendu conducteur que lorsque la tension aux bornes de la ligne à retard est inférieure au seuil de désamorçage du thyristor 17.

La tension aux bornes de la ligne à retard est mesurée à l'aide d'un pont diviseur capacitif comportant les condensateurs 21 et 22. Le point commun de ces deux condensateurs est connecté à une première borne d'entrée 25 d'un comparateur 23 dont l'autre entrée 26 est connectée à un circuit de seuil 27 dont la tension de sortie est ajustable. La borne de sortie du comparateur 23 est connectée à une borne d'entrée d'un circuit logique ET 24 dont l'autre borne d'entrée est connectée au circuit de commande 18.

Le circuit de commande 18 fournit, outre l'impulsion de commande d'amorçage du thyristor 17, une impulsion de commande d'amorçage du thyristor 20. Cependant, cette dernière impulsion n'est pas appliquée directement au thyristor 20 comme dans l'art antérieur, mais par l'intermédiaire du circuit logique ET 24 qui n'est ouvert que lorsque, à l'entrée du comparateur 23, la tension aux bornes de la ligne à retard devient inférieure à une certaine valeur de seuil correspondant à la tension de désamorçage du thyristor 17.

L'impulsion de commande d'amorçage du thyristor 20 est généralement synchronisée avec l'impulsion de commande d'amorçage du thyristor 17 de manière à apparaître un temps de retard fixé après cette dernière. Si à son instant d'apparition, le thyristor 17 n'est pas désamorcé, le comparateur 23 n'aura pas changé d'état de sorte que le circuit logique ET 24 restera fermé : l'impulsion de commande de recharge ne sera pas appliquée au thyristor 20. Tant que le thyristor 17 n'est pas désamorcé, aucune impulsion de commande ne sera appliquée au thyristor 20 et la source d'alimentation 12 ne pourra pas être mise en court-circuit par le thyristor 17 qui dans ce cas reste conducteur.

De ce fait le circuit de protection de surintensité de la source d'alimentation 12 ne sera pas sollicité, le modulateur est toujours en état de marche. L'impulsion de déclenchement suivante pourra être appliquée si la condition de désamorçage du thyristor 17 est satisfaite. Le fonctionnement du modulateur reprendra normalement. Il n'y aura donc pas d'arrêt du modulateur, une seule ou éventuellement quelques impulsions de puissance seront manquantes.

Le dispositif de protection qui vient d'être décrit peut présenter de nombreuses variantes, sans sortir du cadre de la présente invention. Notamment, les thyristors 17 et 20 peuvent être, de manière générale, des commutateurs commandés ; également, la tension peut être mesurée au point E.

Une autre variante consisterait à surveiller le courant circulant dans le circuit de décharge de la ligne à retard.

## Revendications

1. Dispositif de protection d'un modulateur à ligne à retard du type comprenant un premier commutateur (20) pour permettre la charge de la ligne à retard (11) et un deuxième commutateur (17) pour permettre la décharge de la ligne à retard dans le circuit d'utilisation, la fermeture desdits premier et deuxième commutateurs étant commandée par des impulsions de commande, caractérisé en ce qu'il comprend des premiers moyens (21, 22, 23, 27) pour fournir un signal de sortie lorsque la tension aux bornes de la ligne à retard est inférieure au seuil de conduction du deuxième commutateur (17) et des deuxièmes moyens (24) pour autoriser la fermeture du premier commutateur (20) lorsque lesdits premiers moyens fournissent ledit signal de sortie.

2. Dispositif de protection d'un modulateur a ligne à retard selon la revendication 1, caractérisé en ce que les premiers moyens comprennent un diviseur de tension capacitif (21, 22) dont la borne de sortie est connectée à un circuit comparateur (23).

3. Dispositif de protection d'un modulateur à ligne à retard selon la revendication 1 ou 2, caractérisé en ce que les deuxièmes moyens comprennent un circuit logique (24) qui est ouvert par le signal de sortie desdits premiers moyens de manière à laisser passer l'impulsion de commande du premier commutateur (20) qui lui est appliquée.

**Patentansprüche**

1. Schutzvorrichtung für einen Verzögerungsleitungs-Modulator vom Typ mit einem ersten Schalter (20), um die Aufladung der Verzögerungsleitung (11) zu ermöglichen, und mit einem zweiten Schalter (17), um die Entladung der Verzögerungsleitung imr Verbraucherkreis zu ermöglichen, wobei das Schließen des genannten ersten Schalters und zweiten Schalters durch Steuerimpulse gesteuert ist, dadurch gekennzeichnet, daß sie erste Mittel (21, 22, 23, 27) zur Abgabe eines Ausgangssignals, wenn die Spannung an den Klemmen der Verzögerungsleitung geringer als die Leitungsschwelle des zweiten Schalters (17) ist, sowie zweite Mittel (24) zur Freigabe des Schließens des ersten Schalters (20) umfaßt, wenn die genannten ersten Mittel das genannte erste Ausgangssignal abgeben.

2. Schutzvorrichtung für einen Verzögerungsleitungs-Modulator nach Anspruch 1, dadurch gekennzeichnet, daß die ersten Mittel einen kapazitiven Spannungsteiler (21, 22), dessen Ausgangsklemme an eine Romparatorschaltung (23) angeschlossen ist, umfassen.

3. Schutzvorrichtung für einen Verzögerungsleitungs-Modulator nach Anspruch 1 oder 2, dadurch gekennzeichnet, daß die zweiten Mittel eine Logikschaltung (24) umfassen, die durch das Ausgangssignal der genannten ersten Mittel in solcher Weise geöffnet wird, daß sie den daran angelegten Impuls zur Steuerung des ersten Schalters (20) durchlägt.

**Claims**

1. A device for the protection of a delay line modulator of the type comprising a first switch (20) in order to permit the charging of the delay line (11) and a second switch (17) in order to permit the discharging of the delay line into the user circuit, the closing of the said first and second switches being controlled by control pulses, characterized in that it comprises first means (21, 22, 23 and 27) in order to supply an output signal when the voltage at the terminals of the delay line is less than the conduction threshold of the second switch (17) and second means (24) in order to enable the closing of the first switch (20) when the said first means supply the said output signal.

2. The device for the protection of a delay line modulator as claimed in claim 1, characterized in that the first means comprise a capacitive voltage divider (21 and 22) whose output terminal is connected with a comparison circuit (23).

3. The device for the protection of a delay line modulator as claimed in claim 1 or claim 2, characterized in that the second means comprise a logic circuit (24) which is opened by the output signal of the said first means in such a manner as to allow the passage of the control pulse of the first switch (20) which is applied to it.

## FIG_1

## FIG_2

## FIG_3

# FIG_4